# EUROPEAN PATENT APPLICATION

(11) **EP 1 450 174 A1**
(43) Date of publication of application: **25.08.2004**
(21) Application number: 04290398.9
(22) Date of filing: 13.02.2004
(51) Int. Cl.: G01R 31/36, H01M 10/48

(54) **Battery state of charge indicator**

(30) Priority: 14.02.2003 US 447356 P; 12.02.2004 US 776597 P
(71) Applicant: SAFT, Société Anonyme, 93170 Bagnolet (FR)
(72) Inventor: Sink, Michael S., Boone, NC 28607 (US)
(74) Representative: Cabinet Hirsch

(57) **Abstract**

A system and an apparatus for determining the state of charge of a battery, the battery (4) has a sensing device to measure the battery capacity. A reusable state of charge indicator (1) has a microprocessor compatible with different battery types and pre-programmable to determine state of charge based on value received from the sensing device. The battery and the state of charge indicator are electrically connected using one or more contact (3a-3c, 8a-8c) for providing voltage drop information from the sensing device to the microprocessor. This state of charge indicator (1) is removably attachable to the battery (4).

## Description

A method and an apparatus consistent with the present invention relates to determining the state of charge of a battery. More particularly, the present invention is consistent with providing a state of charge indicator for a variety of batteries.

In a battery operated device, low battery can result in possible shut-off of the device, which is a great irritation to the user, especially when the timing of this event cannot be predicted. Therefore, some batteries have built-in indicators showing the remaining capacity of the battery. These state of charge indicators ("SOCI") are relatively expensive, increasing the overall cost of the battery. In addition, SOCI draws a small discharge current even during storage, thereby reducing the capacity of the battery prior to its actual use.

For example, it is not uncommon to store a lithium primary battery for an extended period of time. However, such storage can result in the consumption of a significant amount of the available battery capacity by SOCI to maintain memory of the remaining capacity even when the battery is inactive. Due to these problems, SOCI are not used with smaller, low cost batteries.

Attempts in the industry have been made to solve these problems. The industry is working towards reducing the cost of SOCI devices, which in turn leads to sacrificing the overall accuracy and performance of these indicators. For example, the use of an external state of charge instrument has been considered. This type of instrument measures the effective internal resistance of the battery. However, the measurement from this external indicator is inaccurate partially due to the varying use and storage conditions of the batteries.

Another solution aimed at preventing the draining of the battery capacity during storage is provided in U.S. Patent No. 6,270,916 to Michael Sink. This reference teaches incorporating into a battery an external pull switch, which will activate the SOCI only when the battery is placed in use. This reference is incorporated herein by reference for its helpful background information. However, this switch does not reduce the cost of the SOCI device.

In the automotive industry, a monitoring device for a rechargeable, starting, lighting and ignition (SLI) battery is taught in U.S. Patent No. 5,159,272 to Rao et al. This reference is incorporated herein by reference for its helpful background information. Rao teaches a monitoring device which may be removed from a battery. This removable monitoring device has logic integrated circuits for monitoring the state of charge of the SLI battery and indicators for indicating state of charge of the battery. Rao's monitoring device is designed for use with SLI batteries only and is installed during storage thereby draining the capacity of the SLI battery prior to use.

Moreover, it is known to use built-in SOCI devices. These SOCI devices are incorporated into the compartment of a battery, which houses battery cells. In addition, an external pull switch is provided. Once a new battery cells or new cell pack is installed into the compartment, the pull switch is turned ON to provide power to the SOCI device. When the battery cells are removed, the switch is switched to an OFF state, and the SOCI is reset for use with another set of battery cells.

This design is particularly effective for the type of batteries where the cell pack is replaceable while the compartment of the battery is reusable. However, the battery cells may not function without the housing, thereby each battery put to use would have this SOCI device. Moreover, these SOCI devices would not be reusable with different types of battery cells.

To solve the above-described problem, it is an aspect of the present invention to provide a removably attachable state of charge indicator accurately indicating the state of charge of a battery, reusable with different types of batteries.

To further solve the above-described problem, it is an aspect of the present invention to provide an apparatus and a system capable of providing accurate state of charge while not draining the battery's capacity during storage.

To further solve the above-described problem, it is an aspect of the present invention to provide an apparatus and a system capable of providing accurate state of charge while not interfering with the functionality of the battery, thereby allowing the battery to function with or without a state of charge indicator.

According to the present invention, a state of charge indicator which attaches to a battery includes a housing, a microprocessor disposed in the housing for determining the current state of charge for different battery types, a sensing device located in the housing or the battery and electrically connected to the microprocessor, for measuring voltage drop in the battery. The housing of this state of charge indicator is removably attachable to the battery.

Moreover, according to the present invention, a system of determining state of charge of a battery includes a battery with a sensing device to measure battery capacity and a reusable state of charge indicator with a microprocessor compatible with different battery types and operable to determine the state of charge of a battery based on value received from the sensing device. The system also includes one or more contacts electrically connecting the state of charge indicator to the battery for providing voltage drop information from the sensing device to the microprocessor. The state of charge indicator is removably attachable to the battery.

Finally, according to the present invention, another system of determining state of charge of a battery includes a battery with a sensing device to measure battery capacity and a reusable state of charge indicator having a microprocessor to determine state of charge of the battery based on value received from the sensing device. This system also includes one or more contacts electrically connecting the state of charge indicator to the battery for providing voltage drop information from said sensing device. The state of charge indicator is removably attachable to the battery.

In order to understand the invention and to see how it may be carried out in practice, illustrative, non-limiting embodiments will now be described, with reference to the accompanying drawings, in which:
**Fig. 1** shows a battery and a state of charge indicator in accordance with the first illustrative, non-limiting embodiment of the present invention.
**Fig. 2** is a detailed block diagram of a state of charge indicator and a battery in accordance with the first illustrative, non-limiting embodiment of the present invention.
**Fig. 3** shows a small battery and state of charge indicator in accordance with the second illustrative, non-limiting embodiment of the present invention.
**Fig. 4** is a block diagram of a state of charge indicator in accordance with the third illustrative, non-limiting embodiment of the present invention.
**Fig. 5** is a flow chart diagram of using a SOCI device according to these illustrative, non-limiting embodiments of the present invention.

The present invention will now be described in detail by describing illustrative, non-limiting embodiments thereof with reference to the accompanying drawings. In the drawings, the same reference marks denote the same elements.

The invention is directed to a reusable, plug-in SOCI, which can be attached to a number of different battery types such as primary LiSO₂, rechargeable LiIon, LiSOCl₂, LiMnO₂ and other types of lithium batteries. Moreover, SOCI is a modular molded or otherwise constructed device capable of connecting to battery types of different sizes as for example, BA-XX12, BA-XX90, BA-XX98, BA-XX57, and others in the military range as covered by MIL-PRF-49471B.

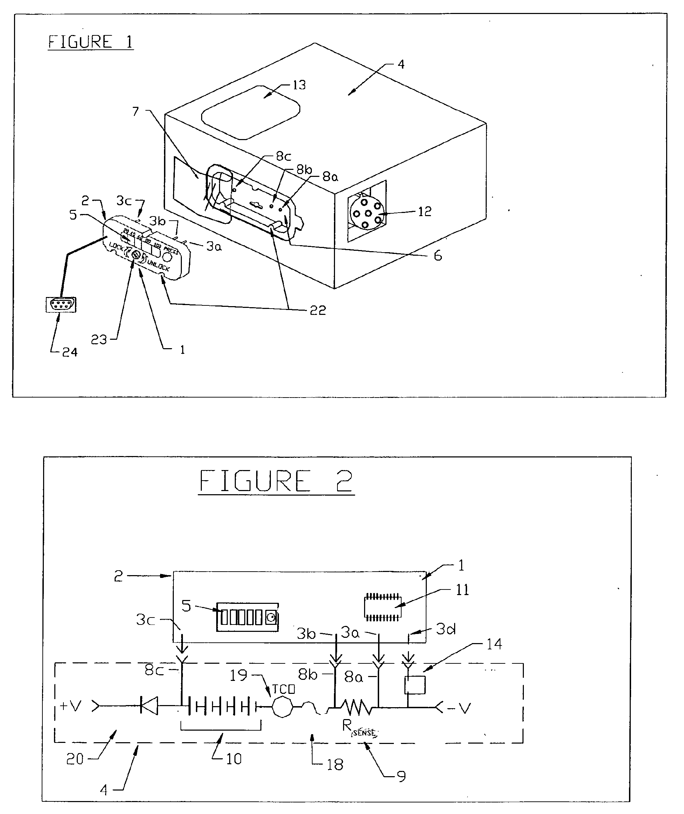

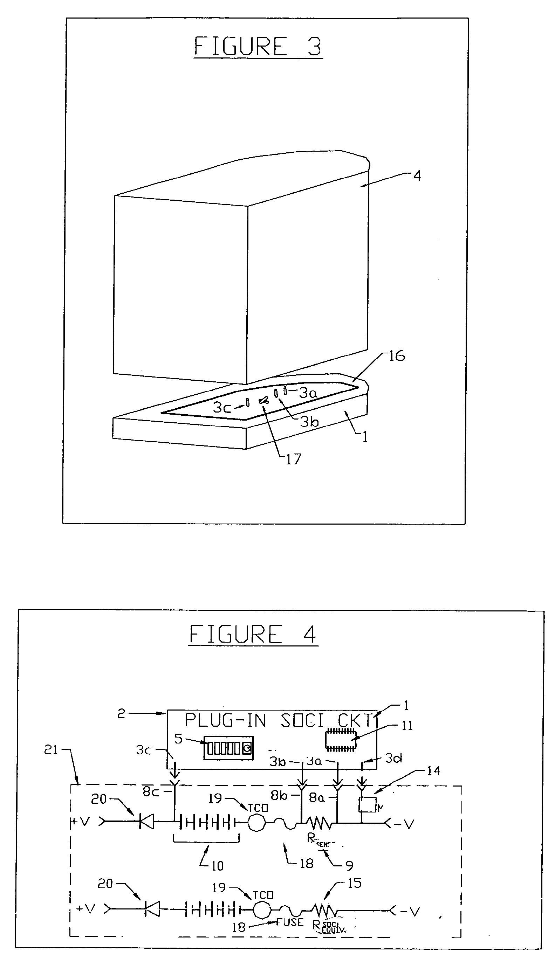

Figs. 1 and 2 show an illustrative, non-limiting embodiment of a plug-in SOCI 1. This SOCI 1 includes a housing 2 having a microprocessor 11 for determining the current capacity of a battery 4. This housing 2 may be attached and removed from the battery 4. In other words, housing 2 of SOCI 1 plugs into the battery 4. The housing 2 can preferably have a unique mechanical shape and keying features 22 such that it fits only the batteries with which it is intended to be used. Also the mechanical shape and keying features 22 allow for insertion into the battery 4 in only one orientation for proper mating of the interconnecting electrical contacts.

There is also a sensing device 9 such as a low value resistor, which measures the voltage drop in the battery and supplies the value to the microprocessor. In the non-limiting embodiment illustrated in Figs. 1 and 2, the sensing device 9 is located in the battery 4, details are provided below. Alternatively, the sensing device 9 can be placed in the housing 2 of SOCI 1.

The battery 4 and the SOCI 1 are electrically connected by using contacts 3a, 3b and 3c. For example, these contacts 3a, 3b and 3c may be pins. These contacts provide power such as DC voltage to SOCI 1 and also provide output such as voltage drop from the sensing device 9 to the microprocessor 11 disposed in the housing 2. However, the number of contacts is not set. For example, SOCI 1 may be connected by more than three contacts for other useful or desirable input and output information applicable to the use of SOCI 1. Also, for example, SOCI 1 could be powered by its own self-contained power source (not shown) and not require power from the battery 4. In this case less than three contacts would be required.

A display 5 may be provided in the housing 2 of SOCI, which may include an LCD or LED or some other visual means for displaying the state of charge of the battery 4. Alternatively or in addition to the visual means, audible means may be used to, for example, provide an audible signal regarding the state of charge of the battery 4. Moreover, SOCI's housing 2 may also have means for outputting the battery's current capacity or other information such as a malfunctioning of a battery to an external device. For example, this information may be output via serial connectors to the battery itself, a personal computer or elsewhere. As illustrated in Fig. 1, information from the SOCI 1 is output to a personal computer 24.

An illustrative battery 4, as shown in Fig. 1, has a cavity 6 for accepting the SOCI 1. Cavity 6 is, preferably, covered with a label 7, which indicates that the battery is new and has not been used yet. The label 7 is removed when the battery 4 is ready for use with SOCI 1. However, when the battery 4 is used without SOCI 1, it is not necessary to remove the label 7.

Label 7 covers mating contact receptacles 8a, 8b and 8c provided with the battery 4, which correspond to the three contacts 3a, 3b and 3c, respectively, so as to electrically connect the SOCI 1 to the battery 4. If additional contacts are provided on the SOCI's housing 2 to allow additional information to be transmitted, then corresponding receptacles are needed on the battery 4. Moreover, battery 4 has a load connector 12 for connecting to the load and a battery label 13 indicating type of the battery 4. In addition, an interlocking device 23 may be provided to lock the SOCI 1 into the battery 4. The battery 4 may function with or without the SOCI 1.

Next, a detailed description of an illustrative, non-limiting embodiment of the plug-in SOCI device 1 and the battery 4 is provided with reference to Fig. 2. To begin, battery 4 has a string of cells 10 (alternatively, a single cell may also be used) and a negative and a positive power output. This power output is provided as input to the SOCI 1, where the negative power input is provided via receptacle 8b and contact 3b and the positive power input is provided via receptacle 8c and contact 3c. As noted above, the battery 4 includes the sensing device 9 which in this particular embodiment is a sense resistor used for measuring discharge current information from voltage drop across the sense resistor 9 through contacts 3a and 3b.

The measured discharges are transferred to SOCI's microprocessor 11 via contact 3a. The micro-processor 11 counts down the remaining capacity based on coulombic drainage, voltage or some other measurements used by the battery 4. In order for the SOCI 1 to be operable on different types of batteries, the programming of the microprocessor 11 and the design of the sensing device 9 will be based partially on algorithms provided by the manufacturer. Using the sensing device 9 for sensing the current requires it to be in the main current flow path. It is feasible that the connector interface could provide for bypassing the main current through the SOCI 1 such that the sensing device 9 could be in the SOCI 1.

Referring to Fig. 2, the battery 4 has a negative terminal V- and a positive terminal V+. Once a load is connected to the battery 4, V- supplies current to the sensing device 9 of the battery 4, which senses the current flowing from V- to V+. Next, output from the sensing device 9 is supplied to the microprocessor 11 via contact 2a to count down the coulombic drain from the battery 4. The information is translated into relative remaining capacity and is displayed on the display 5.

Next, as shown in Fig. 2, the battery 4 has standard safety components such as a fuse 18, a thermal cutoff (TCO) 19, sometimes referred to as a thermal one-shot fuse, and a diode 20. The fuse 18, TCO 19 and diode 20 are standard safety components often included in battery designs. Preferably, these standard safety components are included after the sensing device 9 so that the SOCI 1 will not function if the fuse 18 or TCO 19 is open. In this illustrative embodiment, SOCI device 1 would not be supplied with negative input if the fuse 18 or TCO 19 is open.

For a single SOCI design to cover multiple chemistries in the same battery configuration, the value from the sensing device 9 can be used as the multiplier factor to match microprocessor's 11 pre-programmed or programmable capacity to the chemistry. Preferably, the microprocessor 11 uses Ohm's law to translate the voltage drop across the sensing device 9 into the current. The microprocessor 11 further integrates time and current to calculate coulombic drain from the battery. Preferably, the microprocessor 11 is pre-programmed or programmed to start with 100% capacity level and to count down the capacity level.

For example, one battery may have 10 Ah capacity and a SOCI based on a 0.025 ohm sense resistor. Then, the sense resistor for a battery having 8 Ah capacity, would need to count down at a factor of 10/8 to accurately display the capacity of the 8 Ah battery. Therefore, the value of the sense resistor for the 8 Ah battery with this SOCI would be 1.25 x 0.025 = 0.0313 ohm. In other words, a 10 Ah battery discharged at 1 amp and would last for ten hours and an 8 Ah battery would last for eight hours.

For the 10 Ah battery, the microprocessor would receive a voltage drop of 0.025V(1 amp x 0.025 ohm) from the sense resistor and calculate this to be 1 amp. As a result, after one hour at this rate, the microprocessor would deduct 1 Ah from 10 Ah and report the remaining capacity to be 90%. After ten hours, the capacity reported would be 0%.

For the 8 Ah battery with 0.0313 ohm sense resistor, the 1 amp drain would measure a voltage drop of 0.0313V(1 amp x 0.0313 ohm). The microprocessor would calculate this to be 1.25A. After one hour at this rate, the microprocessor would deduct 1.25 Ah from 10 Ah and report 87.5% capacity remaining. After eight hours of draining the 8 Ah battery at this rate, the microprocessor would deduct 10 Ah and report 0% capacity. Thus, accurately matching the actual drain from the 8 Ah battery, which is 1A in an hour.

The compensation factors for rate and temperature would be close enough to allow for a table with resistor values according to the cell capacity of each device. This table would be referenced for pre-programming or programming SOCI. Thereby, the same SOCI device may be used for different batteries of different manufacturers. For example, the same SOCI device may be used for 10 Ah LiMn02 BA-5390 of one manufacturer and 7.5 Ah LiSO2 BA-5590 of another manufacturer. However, the values from the sensing device for the microprocessor must be properly adjusted for each battery type by referencing the table with the resistor values.
Selection of the sense resistor value must be as low as possible to minimize impact on battery output but still supply sufficient voltage drop to match the sensitivity of the SOCI components to enable accurate measurement of the battery's current.

Finally, the batteries must be redesigned to provide a cavity 6 shown in Fig. 1 and an interface such as receptacles 8a, 8b and 8c for connecting the battery to the SOCI device. This will require some electrical and mechanical design changes as explained above.

The microprocessor 11 is simply programmable according to the capacity and other parameters specific to each battery configuration as provided by the manufacturer. Preferably, the SOCI device 1 automatically resets once it is removed from battery 4. However, it may be desirable to be able to remove the SOCI 1 and then reinstall it into the same battery 4, which at this point is partially used. In other words, the user may not want to reset the SOCI each time it is unplugged from the battery 4. To avoid the automatic resetting upon removal of a battery 4, a memory chip 14 (shown in Fig. 2) would need to be built into the battery 4, to read and write to the state of charge of the battery 4.

Therefore, once the SOCI 1 is disconnected from the battery, the memory chip 14 has the last read capacity of the battery and upon re-connection of SOCI 1 or a different SOCI with the battery 4, SOCI 1 will read the last value stored in the memory chip 14 and continue calculating the present capacity of the battery 4 from the value read, as opposed to being reset to full capacity. This memory chip 14 may be connected directly to the SOCI via additional contact 3d (shown in Fig. 2).

As a result, these plug-in SOCI devices are extremely cost-effective. For example, they do not drain the capacity of the battery during storage. No investment is needed on SOCI devices for inventory batteries. Moreover, these SOCI devices are only needed for the number of batteries in use. If for some reason a SOCI is not needed for a particular battery, then the battery will function equally well without this SOCI device. SOCI does not interfere with the function of the battery.

For example, military uses a number of batteries for training and in combat. In fact, military has a large inventory of batteries. Batteries used in training may be reused if they have remaining capacity. Therefore, SOCI devices are beneficial for batteries used in training. However, in combat, only new batteries are used as such SOCI devices are unnecessary for this type of usage. Since the SOCI devices of the present invention do not interfere with the functionality of the battery, SOCI devices may be used only with batteries in training, whereas this same battery may be used without the SOCI in combat.

In addition, SOCI is reusable for all chemistries in a particular battery configuration. Moreover, SOCI is reusable with different types of batteries having a sensing devices build into the battery. The majority of cost associated with the SOCI device is in the microprocessor and the display and those are the reusable components.

In the embodiment discussed above, the SOCI device is plugged into a cavity of the battery. However, some battery types, especially the smaller batteries such as BA-XX12 and BA-XX88 may require a different design as discussed in second and third exemplary, non-limiting embodiments. Similarly, BA-XX12 must be designed to have a water-tight interface and robustness to endure rugged handling.

The second illustrative, non-limiting embodiment of the present invention is directed to externally attaching SOCI module 1 to a surface of the battery 4 as illustrated in Fig. 3. In this second embodiment, the SOCI module 1 would be affixed with a sealing feature such as an O-ring 16 and secured to a face of the battery 4 with a quick connecting fastener 17. The SOCI module 1 would also be electrically connected to the battery 4 via contacts 3a, 3b and 3c, previously discussed in the first embodiment.

In addition, other variations are possible for specific battery configurations consisting of multiple battery legs such as the BA-XX90 and BA-XX57. The third illustrative, non-limiting embodiment is directed to a dual leg battery 21, where the SOCI device 1 is attached to only one leg of the battery 21. Incorporation of the SOCI module 1 in this configuration must include addition of series resistor 15 in leg of the battery 21 not having the SOCI as shown in Fig. 4. This is necessary to assure balanced discharge of the multiple legs and accurate measurement of capacity. Other features shown in Fig. 4 are similar to the features discussed above with reference to Figs. and 2.

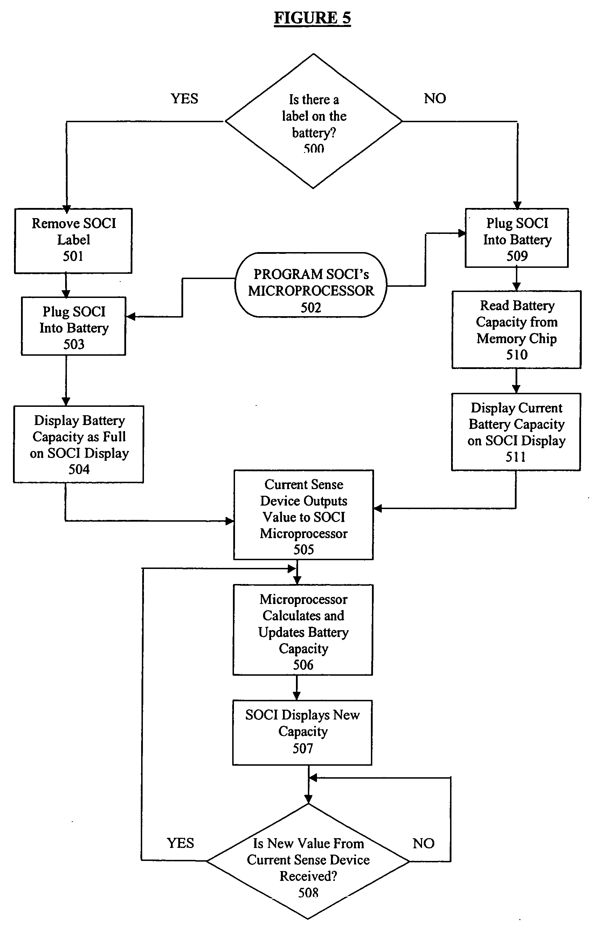

Next, an illustrative, non-limiting operation of the SOCI will be described with reference to Fig. 5. First, at step 500, the user checks whether the battery has a label indicating that this is a new battery. If there is a label, it is removed at step 501 and the SOCI is attached to the battery at step 503. The SOCI's microprocessor is pre-programmed according to the battery type as shown in step 502. In addition, a table with resistor values is referenced so that the SOCI's microprocessor can cover a particular chemistry of the battery it is connected to.

At step 504, SOCI display shows battery capacity to be full. Next, at step 505, a value of the voltage drop from the sensing device is received by the microprocessor and at step 506, the microprocessor calculates the current capacity of the battery. New battery capacity is displayed on the SOCI's display at step 507. Finally, the microprocessor waits for a new value from the sensing device at step 508. If a new value is received, steps 506-508 are repeated.

Alternatively for the case where the battery contains a memory device to store the battery capacity and there is no label, at step 500 the SOCI is plugged into the battery at step 509, and the SOCI's microprocessor reads the capacity stored in memory chip of the battery at step 510. Next at step 511, the SOCI pre-programmed to this particular type of battery in step 502, displays the battery's current state of charge at step 511. From hereon, the process is similar to the one described above, steps 506-508 are repeated until the SOCI is disconnected from the battery.

The above and other features of the invention including various and novel details of the process and construction of the parts has been particularly described with reference to the accompanying drawings and pointed out in the claims. It will be understood that the particular process and construction of parts embodying the invention is shown by way of illustration only and not as a limitation of the invention. The principles and features of this invention may be employed in varied and numerous embodiments without departing from the scope of the invention.

## Claims

1. A state of charge indicator (1) for determining the current capacity of a battery, comprising:
a housing (2);
a microprocessor (11) disposed in said housing and operable to determine current state of charge for a plurality of different battery (4) types; and
a sensing device (9) located in one of said housing and said battery, and electrically connected to said microprocessor, to measure voltage drop in said battery;
wherein said housing (2) is removably attachable to said battery (4).

2. The state of charge indicator according to claim 1, wherein the housing (2) is constructed with a unique shape and keyed (22) such that it will fit only into appropriate said plurality of different battery types.

3. The state of charge indicator according to claim 1 or 2, wherein the housing (2) is constructed with a unique shape and keyed (22) so as to fit into said battery in only one orientation for proper mating of interconnecting electrical contacts (8a-8d, 3a-3d).

4. The state of charge indicator according to any one of claim 1 to 3, further comprising a sealing feature (16) for affixing said housing (2) to the battery (4).

5. The state of charge indicator according to any one of claim 1 to 4, further comprising a fastener (17) for securing said housing (2) to the battery (4).

6. The state of charge indicator according to any one of claim 1 to 3, wherein said housing (2) is plugged into said battery (4).

7. The state of charge indicator according to any one of claim 1 to 6,
wherein said sensing device (9) is electrically connected to said microprocessor (11) through at least one contact for measuring the voltage drop in said battery and wherein said at least one contact further provides power to said microprocessor.

8. The state of charge indicator according to any one of claim 1 to 7,
wherein said microprocessor (11) is pre-programmable to determine state of charge of a particular type of battery chosen from said plurality of different battery types.

9. The state of charge indicator according to any one of claim 1 to 7,
wherein said microprocessor (11) is programmable to determine state of charge of a particular type of battery chosen from said plurality of different battery types.

10. The state of charge indicator according to any one of claim 1 to 9, further comprising a display (5) disposed in said housing (2) operable to show the current state of charge of said battery (4).

11. The state of charge indicator according to claim 8, wherein said display (5) has a fuel gage showing the current charge of said battery.

12. The state of charge indicator according to any one of claim 1 to 11,
wherein said housing comprises means for outputting the current state of charge to an external device.

13. The state of charge indicator according to claim 12,
wherein said external device comprises at least one of an audio means and a video means.

14. The state of charge indicator according to any one of claim 1 to 13,
wherein when said microprocessor (11) is removed from said battery (4), said microprocessor is automatically reset.

15. The state of charge indicator according to any one of claim 1 to 14,
wherein when said microprocessor is removed from said battery and reinstalled into said battery, said microprocessor reads a state of charge stored in said battery.

16. The state of charge indicator according to any one of claim 1 to 15,
wherein said sensing device (9) is in the housing (2).

17. The state of charge indicator according to any one of claim 1 to 15,
wherein said sensing device (9) is in the battery (4).

18. The state of charge indicator according to any one of claim 1 to 17,
wherein said sensing device (9) is a sense resistor.

19. The state of charge indicator according to any one of claim 1 to 18,
wherein said at least one contact (3a-3d, 8a-8d) electrically connects said microprocessor (11) to said battery (4) for providing additional information from said battery.

20. A system of determining state of charge of a battery comprising:
a battery (4) having a sensing device (9) to measure battery capacity;
a reusable state of charge indicator (1) having a microprocessor (11) to determine state of charge based on value received from said sensing device; and
at least one contact (3a-3d, 8a-8d) electrically connecting said state of charge indicator (1) to said battery (4) for providing voltage drop information from said sensing device,
wherein said state of charge indicator (1) is removably attachable to said battery (4).

21. The system of determining state of charge of a battery according to claim 20, wherein said microprocessor (11) is compatible with different battery types.

22. The system of determining state of charge of a battery according to claim 20 or 21, wherein said microprocessor (11) is pre-programmable for a particular battery type chosen from said plurality of battery types.

23. The system of determining state of charge of a battery according to claim 20 or 21, wherein said microprocessor (11) is programmable for a particular battery type chosen from said plurality of battery types.

24. The system of determining state of charge of a battery according to any one of claim 20 to 23, wherein said state of charge indicator (1) is externally attached to one surface of said battery (4).

25. The system of determining state of charge of a battery according to any one of claim 20 to 24, further comprising a sealing feature (16) to affix said state of charge indicator to said battery.

26. The system of determining state of charge of a battery according to any one of claim 20 to 25, further comprising a fastener (17) for securing said state of charge indicator to said battery.

27. The system of determining state of charge of a battery according to any one of claim 20 to 25, wherein said battery has at least two legs and said state of charge indicator is attached to one leg of said at least two legs and each other leg of said at least two legs has a series resistor for balanced discharge.

28. The system according to any one of claim 20 to 27, wherein said at least one contact provides power to said microprocessor.

29. The system according to any one of claim 20 to 28, further comprising display means (5) for displaying the current state of charge of said battery.

30. The system according to claim 29, wherein said display means is a fuel gage.

31. The system according to claim 29 or 30, wherein said display means is disposed in said state of charge indicator.

32. The system according to any one of claim 29 to 31, wherein said display means is one of an audio device and a visual device, connected to said state of charge indicator via output means.

33. The system according to any one of claim 20 to 32, wherein said battery is a lithium battery.

34. The system according to any one of claim 20 to 32, wherein said battery is in military range covered by MIL-PRF-49471B.

35. The system according to any one of claim 20 to 34, wherein said battery further comprises a memory chip (14), and said at least one contact electrically connects said microprocessor with said memory chip.

36. The system according to any one of claim 20 to 35, wherein said battery further comprises a plurality of receptacles corresponding to said plurality of contacts in said state of charge indictor and a label (7) covering said receptacles.

37. The system according to any one of claim 20 to 36, wherein said battery has a cavity (6) and wherein said state of charge indicator plugs into said cavity of said battery.

38. The system according to claim 37, wherein said battery cavity (6) is uniquely shaped and keyed (22) and wherein said state of charge indicator mates with said cavity and is designed for a particular plurality of batteries

39. The system according to claim 37 or 38, wherein said battery cavity is uniquely shaped and keyed and wherein said state of charge indicator fits only in a proper orientation for mating with appropriate electrical interconnecting contact for electrically connecting said state of charge indicator to said battery.

40. The system according to any one of claims 37 to 39, wherein said state of charge indicator (1) is secured in said cavity (6) by using an interlocking device (23).
